# FASCICULE DE BREVET EUROPEEN

(11) **EP 3 485 711 B1**
(45) Date de publication et mention de la délivrance du brevet: **09.09.2020**
(21) Numéro de dépôt: 17735586.4
(22) Date de dépôt: 10.07.2017
(51) Int. Cl.: H05K 7/20

(54) **DISPOSITIF DE REFROIDISSEMENT D'UN CIRCUIT ÉLECTRONIQUE DE PUISSANCE**
VORRICHTUNG ZUM KÜHLEN EINER LEISTUNGSELEKTRONIKSCHALTUNG
DEVICE FOR COOLING A POWER ELECTRONICS CIRCUIT

(30) Priorité: 12.07.2016 FR 1656690
(43) Date de publication de la demande: 22.05.2019
(73) Titulaire: Moteurs Leroy-Somer, 16915 Angouleme Cedex 9 (FR)
(72) Inventeur: BOURLIER, Ludovic, 16000 Angouleme (FR); COURAGE, Aurélien, 69700 Chassagny (FR); CRESPO, Thierry, 16400 Voeil et Giget (FR)
(74) Mandataire: Nony
(86) Numéro de dépôt international: PCT/EP2017/067296
(87) Numéro de publication internationale: WO 2018/011152

(56) Documents cités:
- EP-A1- 2 629 594
- DE-A1-102006 057 796
- DE-A1-102009 029 704
- US-A1- 2015 096 719

## Description

La présente invention concerne les circuits électroniques de puissance et plus particulièrement leur refroidissement.

Classiquement, les variateurs de vitesse pour moteurs électriques comportent des circuits électroniques de puissance qui peuvent dissiper chacun plus d'un kW et dont le refroidissement s'effectue par une circulation d'un liquide.

Le ou les circuits sont fixés sur un dissipateur thermique dans lequel circule un liquide.

DE 10 2006 057 796 et US 2015/0096719 divulguent des dispositifs de refroidissement comportant un dissipateur thermique à circulation de fluide.

Il est connu de placer le ou les circuits à refroidir en contact direct avec le liquide de refroidissement, et le montage sur le dissipateur thermique nécessite l'aménagement d'une zone d'étanchéité.

Un tel montage complique la maintenance du variateur. En effet, l'intervention pour remplacer un circuit électronique de puissance suppose de couper l'alimentation en liquide du dissipateur thermique et de le vidanger. Il en résulte un risque de fuite de liquide sur le ou les circuits électroniques, impliquant un risque pour la sécurité des usagers et/ou du variateur, au montage et/ou au remontage du dissipateur thermique, un temps d'intervention conséquent pour les applications concernées qui sont souvent critiques et qui demandent un taux de disponibilité élevée, et une complexité accrue de la maintenance du fait de devoir faire intervenir au moins deux métiers différents.

Il existe ainsi un besoin pour faciliter la maintenance des variateurs de vitesse et autres appareils électroniques de puissance comportant un ou plusieurs circuits électroniques de puissance devant être refroidis par liquide.

L'invention répond à ce besoin en proposant un dispositif de refroidissement selon la revendication 1.

L'invention facilite la maintenance en permettant l'enlèvement du ou des circuits électroniques de puissance du dissipateur thermique sans avoir à vidanger celui-ci.

L'invention offre également de nouvelles possibilités dans l'agencement du ou des circuits électroniques de puissance relativement au dissipateur thermique.

De préférence, la plaque d'interface est en cuivre ou en aluminium ou dans tout autre matériau bon conducteur thermique, de préférence métallique.

L'épaisseur de la plaque d'interface est par exemple comprise entre 5 et 20 millimètres, étant de préférence supérieure ou égale à 10 millimètres.

La plaque d'interface peut être rigide de façon à contribuer à la stabilité mécanique du dispositif de refroidissement. Le ou les circuits électroniques de puissance peuvent être divers et comporter un ou plusieurs composants électroniques de puissance tels que notamment des transistors de puissance de type IGBT ou MOSFET.

Le dispositif de refroidissement peut recevoir un ou plusieurs circuits électroniques de puissance, par exemple trois circuits électroniques de puissance correspondant aux trois phases du moteur.

Chaque circuit électronique de puissance peut être fixé en un ou plusieurs points sur la plaque d'interface. Par exemple, chaque circuit électronique de puissance est fixé en deux points ou plus, par exemple en quatre points sur la plaque d'interface. Cette fixation peut s'effectuer par exemple à l'aide de vis ou de rivets ou encore à l'aide de pinces élastiques.

Le ou les circuits électroniques de puissance peuvent comporter une semelle, notamment métallique, de préférence électriquement isolée, qui permet un bon contact thermique avec la plaque d'interface.

La semelle peut être au contact de la plaque d'interface avec interposition d'une graisse thermique et/ou d'une feuille de contact thermique en un matériau élastomère bon conducteur de la chaleur.

Dans une variante, le ou les circuits électroniques sont fixés sur une ou plusieurs semelles correspondantes qui sont monobloc avec la plaque d'interface. En présence de plusieurs circuits électroniques de puissance à refroidir, on dispose ceux-ci de préférence sur la plaque d'interface de façon à ce que le refroidissement de ces circuits soit le plus homogène possible.

Par exemple, dans le cas où le dissipateur thermique est parcouru par un canal en serpentin qui fait des aller-retours dans une première direction, on peut avoir intérêt à disposer les composants électroniques de puissance sur toute la largeur du serpentin, côte à côte dans la première direction. Par exemple, les circuits électroniques ont une forme allongée et leur axe longitudinal est perpendiculaire à cette première direction. La largeur du serpentin définit une deuxième direction perpendiculaire à la première.

La plaque d'interface comporte un thermosiphon, visant par exemple à homogénéiser la température de la plaque d'interface ou à permettre le transfert de chaleur d'une première partie de la plaque d'interface à une deuxième partie.

De préférence, la plaque d'interface comporte une face de réception du ou des circuits électroniques de puissance qui est d'étendue au moins sensiblement égale à celle du dissipateur thermique avec laquelle la plaque est en contact. On bénéficie ainsi de la totalité ou de la quasi-totalité de la surface d'échange offerte par le dissipateur thermique.

Dans un exemple de réalisation, la plaque d'interface, le ou les circuits à refroidir et le dissipateur thermique se superposent sans débordement sensible de l'un par rapport à l'autre.

Dans une variante, le ou les circuits à refroidir sont décalés latéralement par rapport au dissipateur thermique.

Le dissipateur thermique peut comporter un ou plusieurs caloducs.

Le dissipateur thermique peut être parcouru par un liquide circulant entre le dissipateur et une source de froid, par exemple une unité de réfrigération. Le liquide peut circuler sans changement de phase.

Dans une variante, le dissipateur thermique est refroidi par un liquide qui subit au moins un changement de phase, par exemple qui se vaporise du fait de la chaleur dégagée par le ou les circuits électroniques à refroidir et qui se condense au niveau de la source de froid.

L'invention a encore pour objet un ensemble comportant le dispositif de refroidissement selon l'invention et au moins un circuit électronique de puissance fixé dessus pour être refroidi.

La puissance dissipée par circuit peut être supérieure ou égale à un kW, voire 2 ou 5 kW.

L'invention a encore pour objet un variateur de vitesse pour moteur électrique comportant un ensemble selon l'invention.

L'invention pourra être mieux comprise à la lecture de la description détaillée qui va suivre, d'exemples de mise en œuvre non limitatifs de celle-ci, et à l'examen du dessin annexé, sur lequel :
- La figure 1 est une vue éclatée et schématique d'un exemple de dispositif de refroidissement selon l'invention, équipé de circuits électroniques de puissance à refroidir,
- la figure 2 est une coupe transversale schématique du dispositif de refroidissement de la figure 1, au niveau d'un circuit électronique de puissance,
- la figure 3 est une vue analogue à la figure 2 d'une variante de réalisation de la plaque d'interface,
- la figure 4 est une autre vue analogue à la figure 2 d'une variante de réalisation,
- la figure 5 représente une variante de réalisation du dissipateur, et
- la figure 6 est une vue analogue à la figure 5 d'une variante de réalisation du dissipateur.

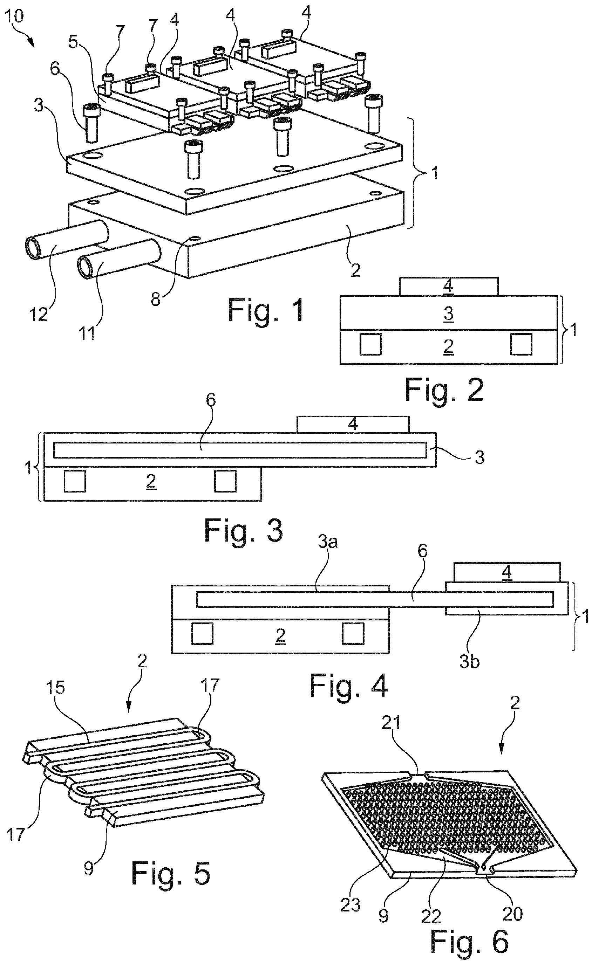

L'ensemble 10 représenté à la figure 1 comporte un dispositif de refroidissement 1 et une pluralité de circuits électroniques de puissance 4, comportant chacun une semelle thermique 5.

Le dispositif de refroidissement 1 comporte un dissipateur thermique 2 qui est surmonté d'une plaque d'interface 3 sur laquelle sont fixés les circuits électroniques 4. Dans l'exemple illustré, la fixation de la plaque d'interface 3 sur le dissipateur thermique 2 s'effectue par boulonnage à l'aide de vis 6, et la fixation des circuits 4 sur la plaque d'interface 3 s'effectue également par boulonnage à l'aide de vis 7.

Les vis 6 sont fixées dans des taraudages correspondants 8 du dissipateur thermique et les vis 7 sont vissées des trous borgnes taraudés de la plaque d'interface 3, non apparents sur la figure 1.

Chaque circuit 4 présente par exemple une forme générale parallélépipédique, étant fixé à chaque coin par une vis 7 sur la plaque d'interface 3.

Le dissipateur thermique est refroidi par une circulation d'un liquide entre une arrivée 11 et une sortie 12. Le fluide qui circule dans le dissipateur 2 est refroidi par une source froide non représentée, par exemple une unité réfrigérante.

Comme on le voit sur la figure 2, le dissipateur thermique 2, la plaque d'interface 3 et les circuits électroniques 4 peuvent être superposés verticalement, c'est-à-dire dans une direction perpendiculaire au plan de la plaque d'interface 3.

Dans la variante illustrée à la figure 3, les circuits électroniques 4 sont décalés latéralement par rapport au dissipateur thermique 2. La plaque d'interface 3 peut déborder latéralement du dissipateur thermique 2 sur au moins un côté, notamment sur deux côtés opposés ou adjacents, voire sur trois ou quatre côtés. De façon à faciliter le transfert des calories dissipées par les circuits électroniques 4, la plaque d'interface 3 peut être munie d'un ou plusieurs thermosiphons 6 s'étendant entre la partie latérale sur laquelle sont fixés les circuits électroniques 4 et le dissipateur thermique 2.

Dans la variante illustrée à la figure 4, la plaque d'interface 3 est réalisée en deux parties disjointes 3a et 3b, la partie 3a étant fixée sur le dissipateur thermique 2 et la partie 3b supportant les circuits électroniques de puissance 4. Les parties 3a et 3b sont reliées par un ou plusieurs thermosiphons 6, lesquels peuvent également assurer la cohésion mécanique de l'ensemble. Dans une autre variante, la cohésion mécanique est assurée au moins partiellement par un support non représenté, duquel le dissipateur 2 et la partie 3b sont solidaires.

Il est possible de réaliser le dissipateur 2 de diverses façons.

Dans un exemple illustré à la figure 5, le dissipateur 2 est parcouru par un caloduc en forme de serpentin. Ce serpentin 9 présente des portions 15 rectilignes qui sont reliées entre elles par des portions arquées 17. Le dissipateur 2 peut comporter une plaque 9 qui est usinée pour définir des logements pour recevoir tout ou partie du serpentin et en particulier les portions rectilignes 15. Le serpentin peut être défini par un tube rapporté, notamment en aluminium. Dans une variante, le ou les caloducs sont directement usinés dans une plaque constitutive du dissipateur.

A titre de variante, on a illustré à la figure 6 un circuit de fluide directement usiné dans la plaque 9 du dissipateur.

Ce circuit de fluide comporte une entrée 20 et une sortie 21, un ou plusieurs canaux 22 de distribution du liquide et une ou plusieurs chicanes 23 permettant d'assurer une bonne répartition du liquide dans toute l'étendue de la plaque ainsi qu'une circulation turbulente, le cas échéant, pour améliorer les échanges thermiques.

Bien entendu, l'invention n'est pas limitée aux exemples qui viennent d'être décrits.

Par exemple, on peut réaliser le dissipateur et/ou la plaque d'interface avec une forme cintrée, de façon par exemple à faciliter la fixation du dispositif de refroidissement sur un carter cylindrique de moteur.

Outre le refroidissement par liquide du dissipateur thermique, on peut prévoir un refroidissement par convection naturelle ou forcée, avec l'air ambiant par exemple.

Pour procéder au remplacement d'un ou plusieurs circuits électroniques de puissance 4, on peut enlever les vis 6 afin de séparer la plaque d'interface 3 du dissipateur 2. Ensuite, on peut procéder au démontage du ou des circuits électroniques endommagés. Après remplacement de ceux-ci, la plaque d'interface peut être fixée à nouveau sur le dissipateur thermique 2. Au cours de ces opérations, la vidange du circuit de liquide de refroidissement n'est pas nécessaire.

L'invention s'applique également, outre le refroidissement de circuits électroniques pour variateurs de vitesses, aux circuits électroniques de conversion d'énergie, notamment onduleurs, hacheurs, redresseurs commandés, ainsi qu'aux régulateurs de puissance pour alternateurs et plus généralement à tous dispositifs d'électronique de puissance.

## Revendications

1. Dispositif de refroidissement (1) d'au moins un circuit électronique de puissance (4), comportant :
- un dissipateur thermique (2) refroidi par liquide; et
- une plaque d'interface (3) en contact thermique avec le dissipateur thermique (2) et sur laquelle le(s) circuit(s) électronique(s) de puissance (4) est/sont fixé(s),
**caractérisé par le fait que** la plaque d'interface (3), comportant au moins un thermosiphon (6), est montée de façon amovible sur le dissipateur thermique (2) de manière à pouvoir être séparée de celui-ci avec le(s) circuit(s) électronique(s) (4) fixé(s) dessus, la plaque d'interface (3) comportant une première partie recouvrant totalement le dissipateur (2) et une deuxième partie reliée à la première par ledit au moins un thermosiphon (6) et surmontée par le(s) circuit(s) à refroidir (4).

2. Dispositif de refroidissement (1) selon la revendication précédente, la plaque d'interface (3) étant en cuivre ou en aluminium.

3. Dispositif de refroidissement (1) selon l'une des deux revendications précédentes, la plaque d'interface (3) ayant une face de réception du/des circuit(s) (4) d'étendue au moins sensiblement égale à celle du dissipateur thermique (2) avec laquelle la plaque (3) est en contact.

4. Dispositif de refroidissement (1) selon l'une quelconque des revendications précédentes, la plaque d'interface (3), le(s) circuit(s) à refroidir (4) et le dissipateur thermique (2) se superposant, sans débordement sensible.

5. Dispositif de refroidissement selon l'une quelconque des revendications précédentes, le dissipateur thermique (2) comportant un ou plusieurs caloducs (9).

6. Ensemble comprenant un dispositif de refroidissement (1) selon l'une quelconque des revendications précédentes et au moins un circuit électronique (4) à refroidir fixé dessus.

7. Ensemble selon la revendication précédente, la puissance dissipée par chaque circuit étant supérieure ou égale à 1 kW, mieux à 2 kW, notamment à 5 kW.

8. Ensemble selon la revendication 6 ou 7, le(s) circuit(s) à refroidir (4) étant décalé(s) latéralement par rapport au dissipateur thermique (2).

9. Ensemble selon l'une quelconque des revendications 6 à 8, chaque circuit électronique (4) comportant une semelle thermique (5), de préférence électriquement isolée, venant en contact avec la plaque d'interface (3).

10. Ensemble selon l'une quelconque des revendications 6 à 9, le(s) circuit(s) électronique(s) (4) comportant et/ou étant constitué(s) par un ou plusieurs composants de puissance choisi(s) parmi les transistors de puissance de type IGBT ou MOSFET.

11. Variateur de vitesse pour moteur électrique comportant un ensemble selon l'une des revendications 6 à 10.

## Patentansprüche

1. Kühlvorrichtung (1) zum Kühlen mindestens einer elektronischen Leistungsschaltung (4), umfassend:
- einen flüssigkeitsgekühlten Wärmeableiter (2) und
- eine Schnittstellenplatte (3), die in thermischem Kontakt mit dem Wärmeableiter (2) ist und auf der die elektronische(n) Leistungsschaltung(en) (4) befestigt ist(sind),
**dadurch gekennzeichnet, dass** die Schnittstellenplatte (3), die mindestens einen Thermosiphon (6) umfasst, abnehmbar auf dem Wärmeableiter (2) montiert ist, so dass sie von diesem mit der (den) auf ihr befestigten elektronischen Schaltung(en) (4) getrennt werden kann, wobei die Schnittstellenplatte (3) einen ersten Teil umfasst, der den Ableiter (2) vollständig bedeckt, und einen zweiten Teil, der mit dem ersten über den mindestens einen Thermosiphon (6) verbunden ist und von der(den) zu kühlenden Schaltung(en) (4) überragt wird.

2. Kühlvorrichtung (1) nach dem vorhergehenden Anspruch, wobei die Schnittstellenplatte (3) aus Kupfer oder Aluminium besteht.

3. Kühlvorrichtung (1) nach einem der beiden vorhergehenden Ansprüche, wobei die Schnittstellenplatte (3) eine Seite zur Aufnahme der Schaltung(en) (4) besitzt, deren Ausdehnung mindestens im Wesentlichen gleich der des Wärmeableiters (2) ist, mit der die Platte (3) in Kontakt ist.

4. Kühlvorrichtung (1) nach einem der vorhergehenden Ansprüche, wobei sich die Schnittstellenplatte (3), die zu kühlende(n) Schaltung(en) (4) und der Wärmeableiter (2) ohne wesentlichen Überstand überlagern.

5. Kühlvorrichtung nach einem der vorhergehenden Ansprüche, wobei der Wärmeableiter (2) ein oder mehrere Wärmeleitrohre (9) umfasst.

6. Anordnung mit einer Kühlvorrichtung (1) nach einem der vorhergehenden Ansprüche und mindestens einer darauf befestigten zu kühlenden elektronischen Schaltung (4).

7. Anordnung nach dem vorhergehenden Anspruch, wobei die Verlustleistung jeder Schaltung größer oder gleich 1 kW, besser größer oder gleich 2 kW, insbesondere größer oder gleich 5 kW ist.

8. Anordnung nach Anspruch 6 oder 7, wobei die zu kühlende(n) Schaltung(en) (4) in Bezug auf den Wärmeableiter (2) seitlich versetzt ist(sind).

9. Anordnung nach einem der Ansprüche 6 bis 8, wobei jede elektronische Schaltung (4) eine Thermosohle (5), die bevorzugt elektrisch isoliert ist, aufweist, die mit der Schnittstellenplatte (3) in Kontakt gelangt.

10. Anordnung nach einem der Ansprüche 6 bis 9, wobei die elektronische(n) Schaltung(en) (4) ein oder mehrere Leistungsbauelemente umfasst(umfassen) und/oder daraus besteht(bestehen), das(die) unter den Leistungstransistoren vom Typ IGBT oder MOSFET gewählt ist(sind).

11. Regelantrieb für einen Elektromotor, der eine Anordnung nach einem der Ansprüche 6 bis 10 umfasst.

## Claims

1. A cooling device (1) for cooling at least one power electronics circuit (4), comprising:
- a liquid-cooled heatsink (2); and
- an interface plate (3) in thermal contact with the heatsink (2) and on which the power electronics circuit or circuits (4) is or are fixed,
**characterized in that** the interface plate (3), which comprises at least one thermosiphon (6), is mounted removably on the heatsink (2) so that it can be detached therefrom with the electronics circuit or circuits (4) fixed on it, the interface plate (3) comprising a first part completely covering the heatsink (2) and a second part connected to the first by said at least one thermosiphon (6) and surmounted by the circuit or circuits (4) to be cooled.

2. The cooling device (1) as claimed in the preceding claim, the interface plate (3) being made of copper or of aluminum.

3. The cooling device (1) as claimed in one of the two preceding claims, the interface plate (3) having a face for accepting the circuit or circuits (4) of which the extent is at least substantially equal to that of the heatsink (2) with which the plate (3) is in contact.

4. The cooling device (1) as claimed in any one of the preceding claims, the interface plate (3), the circuit or circuits (4) to be cooled, and the heatsink (2) being superposed without appreciable overhang.

5. The cooling device as claimed in any one of the preceding claims, the heatsink (2) comprising one or more heat pipes (9).

6. An assembly comprising a cooling device (1) as claimed in any one of the preceding claims and at least one electronics circuit (4) to be cooled fixed on top.

7. The assembly as claimed in the preceding claim, the power dissipated by each circuit being greater than or equal to 1 kW, better 2 kW, notably 5 kW.

8. The assembly as claimed in claim 6 or 7, the circuit or circuits (4) to be cooled being laterally offset with respect to the heatsink (2).

9. The assembly according to any one of claims 6 to 8, each electronics circuit (4) comprising a thermal sole plate (5), preferably electrically insulated, that comes into contact with the interface plate (3).

10. The assembly as claimed in any one of claims 6 to 9, the electronics circuit or circuits (4) comprising and/or being made up of one or more power components selected from power transistors of the IGBT or MOSFET type.

11. A speed variator for an electric motor comprising an assembly as claimed in one of claims 6 to 10.
